# EUROPÄISCHE PATENTSCHRIFT

(11) **EP 2 987 394 B1**
(45) Veröffentlichungstag und Bekanntmachung des Hinweises auf die Patenterteilung: **07.02.2018**
(21) Anmeldenummer: 14708006.3
(22) Anmeldetag: 04.03.2014
(51) Int. Cl.: H05K 7/20

(54) **GLEICHSPANNUNGSWANDLER UND BRENNSTOFFZELLENANLAGE EINES UNTERSEEBOOTES**
DC-DC CONVERTER AND FUEL CELL SYSTEM OF A SUBMARINE
CONVERTISSEUR CONTINU-CONTINU ET INSTALLATION À PILES À COMBUSTIBLE D'UN SOUS-MARIN

(30) Priorität: 22.05.2013 DE 102013209409
(43) Veröffentlichungstag der Anmeldung: 24.02.2016
(73) Patentinhaber: Siemens Aktiengesellschaft, 80333 München (DE)
(72) Erfinder: HOFFMANN, Joachim, 90559 Burgthann (DE); SCHOLZ, Thomas, 23858 Barnitz (DE); TÖLLE, Hans-Jürgen, 90419 Nürnberg (DE); WIETOSKA, Jens, 28279 Bremen (DE); BARTH, Alexander, 22159 Hamburg (DE); BROER, Christian, 31515 Wunstorf (DE); GRIMMIG, Markus, 58256 Ennepetal (DE); KOBISCH, Ulf, 22761 Hamburg (DE); MARQUARD, Helmut, 25492 Heist (DE); SOLMECKE, Heiko, 25436 Moorrege (DE)
(86) Internationale Anmeldenummer: PCT/EP2014/054134
(87) Internationale Veröffentlichungsnummer: WO 2014/187587

(56) Entgegenhaltungen:
- EP-A1- 0 235 657
- EP-A2- 2 552 184
- DE-A1-102006 010 714
- DE-B3-102004 004 624

## Beschreibung

Die Erfindung betrifft einen Gleichspannungswandler zur Anpassung einer elektrischen Gleichspannung. Ferner betrifft die Erfindung eine Brennstoffzellenanlage eines Unterseebootes.

Unter einem Gleichspannungswandler, auch DC-DC-Wandler genannt, wird hier eine elektrische Schaltungsanordnung verstanden, die eine eingangsseitige elektrische Gleichspannung in eine davon verschiedene ausgangsseitige Gleichspannung anpasst.

Bei dem Umwandeln der Gleichspannung treten Wandlungsverluste auf, die den Gleichspannungswandler erwärmen. Die dabei entstehende Wärme muss abgeleitet werden, um eine Zerstörung durch ein mögliches Überhitzen des Gleichspannungswandlers zu verhindern.

Gleichspannungswandler werden insbesondere im Zusammenhang mit Brennstoffzellen eingesetzt, um die von den Brennstoffzellen erzeugte elektrische Gleichspannung anzupassen, beispielsweise in Antriebsanlagen von Unterseebooten zur Anpassung an eine Bordnetzspannung. Dabei werden in der Regel luftgekühlte Gleichspannungswandler in einem Schrankgehäuse mit einem Wärmetauscher und einem Luftumwälzgebläse eingesetzt. Die umgewälzte Schrankluft nimmt die Abwärme auf und gibt sie dann an den Wärmetauscher ab, dessen Kühlmedium entweder Seewasser oder Kühlwasser aus einem zwischen geschalteten Sekundärkreislauf ist. Wegen der geringen Wärmekapazität des eingesetzten Wärmeträgers Luft müssen erhebliche Anstrengungen unternommen werden, um mittels hohen Strömungsgeschwindigkeiten die Wärmeableitung im erforderlichen Umfang zu realisieren. Dazu werden große Gebläse eingesetzt, die zum Einen einen hohen Platzbedarf und hohe elektrische Leistungsaufnahmen haben und zum Anderen eine relativ hohe Geräuschemission verursachen.

DE 197 11 016 A1 offenbart einen Umrichter mit modularem, zumindest zweiteiligem Aufbau mit einem Trägermodul und zumindest einem mit dem Trägermodul verbindbaren und aus dem Trägermodul herausziehbarem Modul.

EP 1 865 569 A1 offenbart ein Verfahren, bei dem Wärme einer Brennstoffzellenanlage an ein erstes Kühlmittel übertragen wird, und bei dem Wärme des ersten Kühlmittels wahlweise an ein zweites Kühlmittel, zum Beispiel Wasser, an ein drittes Kühlmittel, zum Beispiel Luft, oder sowohl an das zweite als auch an das dritte Kühlmittel übertragen wird, wobei die Wärmekapazität des zweiten Kühlmittels unterschiedlich ist zu der Wärmekapazität des dritten Kühlmittels.

DE 10 2004 004 624 B3 offenbart eine U-Boot-Brennstoffzelleneinrichtung mit H₂-O₂-Brennstoffzellen in modularem Aufbau.

EP 0 235 657 A1 offenbart eine Wasserkühleinrichtung für einschiebbare Bauteilgruppen in Geräten der Leistungselektronik. Dabei ist mit jedem im Verband eines Einschubes in ein Gerät eingeschobenen Bauteilträger ein wasserdurchflossener Kühlkörper durch die Kraft federnder Elemente in thermische Wirkverbindung bringbar.

Der Erfindung liegt die Aufgabe zugrunde, eine verbesserte Brennstoffzellenanlage mit Brennstoffzellen für Unterseeboote anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Ein erfindungsgemäßer Gleichspannungswandler zur Anpassung einer elektrischen Gleichspannung umfasst wenigstens einen als Gleichspannungswandlermodul ausgebildeten Leistungseinschub und eine Kühlvorrichtung mit wenigstens einem Kühlkörper, der dazu ausgebildet ist, mittels eines Kühlmediums gekühlt zu werden, und der in direktem thermischem Kontakt mit wenigstens einem Leistungseinschub steht.

Der direkte thermische Kontakt eines Kühlkörpers mit einem Leistungseinschub ermöglicht dabei eine verbesserte Wärmeableitung von dem Leistungseinschub als eine Luftkühlung und somit eine effizientere Kühlung des Gleichspannungswandlers. Eine Ausgestaltung der Erfindung sieht vor, dass der wenigstens eine Kühlkörper dazu ausgebildet ist, von dem Kühlmedium durchströmt zu werden.

Die Durchströmung von Kühlkörpern mit dem Kühlmedium ermöglicht dabei eine besonders gute Kühlung des Kühlkörpers und damit auch des Gleichspannungswandlers.

Eine weitere Ausgestaltung der Erfindung sieht vor, dass der wenigstens eine Kühlkörper dazu ausgebildet ist, durch eine Kühlflüssigkeit als Kühlmedium gekühlt zu werden.

Dies ist vorteilhaft, da eine Kühlflüssigkeit eine bessere Kühlung als beispielsweise ein gasförmiges Kühlmedium ermöglicht. Die Erfindung sieht vor, dass der wenigstens eine Kühlkörper mit wenigstens einem Leistungseinschub kraftschlüssig verbunden ist. Vorzugsweise ist der wenigstens eine Kühlkörper dabei mit wenigstens einem Leistungseinschub verschraubt und/oder verspannt.

Eine kraftschlüssige Verbindung eines Kühlkörpers mit einem Leistungseinschub ist vorteilhaft, da sie einen dauerhaften und guten thermischen Kontakt zwischen dem Kühlkörper und dem Leistungseinschub ermöglicht. Eine Verschraubung und/oder Verspannung des Kühlkörpers mit dem Leistungseinschub ermöglicht eine einfache und wirksame derartige Verbindung des Kühlkörpers mit dem Leistungseinschub.

Eine erfindungsgemäße Brennstoffzellenanlage eines Unterseebootes umfasst wenigstens eine Brennstoffzelle, wenigstens einen mit der wenigstens einen Brennstoffzelle elektrisch verbundenen erfindungsgemäßen Gleichspannungswandler zur Anpassung einer von der wenigstens einen Brennstoffzelle erzeugten Gleichspannung und einen mit der Kühlvorrichtung des wenigstens einen Gleichspannungswandlers thermisch verbundenen Primärkühlkreislauf, der ein Kühlmedium zur Kühlung des wenigstens einen Kühlkörpers der Kühlvorrichtung führt.

Eine erfindungsgemäße Brennstoffzellenanlage eines Unterseebootes ermöglicht durch die Verwendung eines erfindungsgemäßen Gleichspannungswandlers und dessen Ankopplung an einen Primärkühlkreis eine effiziente Kühlung des Gleichspannungswandlers. Insbesondere ist keine Luftkühlung des Gleichspannungswandlers erforderlich, so dass auf ein dafür erforderliches aufwändiges Gebläse verzichtet werden kann, wodurch vorteilhaft Bauraum und Energie eingespart wird und die Geräuschemission des Gebläses vermieden wird.

Eine Ausgestaltung der Brennstoffzellenanlage sieht vor, dass der wenigstens eine Kühlkörper Teil des Primärkühlkreislaufs ist und dazu ausgebildet ist, von dem Kühlmedium durchströmt zu werden.

Die Durchströmung von Kühlkörpern mit dem Kühlmedium und deren Einbindung in den Primärkühlkreislauf ermöglicht eine besonders gute Kühlung der Kühlkörper und damit auch des Gleichspannungswandlers.

Eine weitere Ausgestaltung der Brennstoffzellenanlage sieht vor, dass der Primärkühlkreislauf Meerwasser als Kühlmedium führt.

Auf diese Weise kann vorteilhaft das Unterseeboot umgebendes Meerwasser zur Kühlung des Gleichspannungswandlers verwendet werden.

Eine dazu alternative Ausgestaltung der Brennstoffzellenanlage sieht vor, dass der Primärkühlkreislauf Kühlwasser des Unterseebootes als Kühlmedium führt. Bei dieser Ausgestaltung wird der Primärkühlkreislauf vorzugsweise über einen Wärmetauscher thermisch an einen Meerwasser führenden Sekundärkühlkreislauf gekoppelt.

Auch in dieser Ausgestaltung kann also vorteilhaft das Unterseeboot umgebendes Meerwasser zur Kühlung des Gleichspannungswandlers in einem Sekundärkühlkreislauf verwendet werden. Die Verwendung von Kühlwasser des Unterseebootes als Kühlmedium in dem Primärkühlkreislauf verhindert vorteilhaft die Beeinträchtigung von Komponenten des Primärkühlkreislaufs durch Korrosion und/oder Ablagerungen, die durch Meerwasser verursacht werden können.

Eine zur vorgenannten Ausgestaltung alternative Ausgestaltung der Brennstoffzellenanlage sieht vor, dass der Primärkühlkreislauf Kühlwasser des Unterseebootes als Kühlmedium führt, das von einer bordeigenen Kühlanlage temperiert wird.

Bei dieser Ausgestaltung wird das Kühlwasser immer auf einer konstanten Temperatur gehalten, was die Auslegung des Kühlsystems für die Brennstoffzellenanlage erleichtert.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert werden.

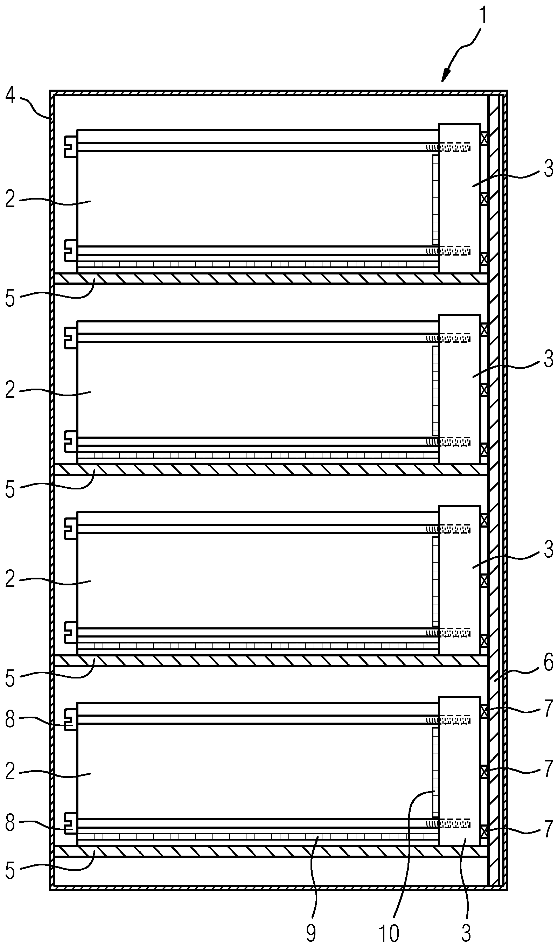

Die einzige Figur zeigt einen Gleichspannungswandler 1, der vier Leistungseinschübe 2 umfasst, die jeweils als ein Gleichspannungswandlermodul ausgebildet sind. Ferner weist der Gleichspannungswandler 1 für jeden Leistungseinschub 2 einen Kühlkörper 3 auf, der mit dem jeweiligen Leistungseinschub 2 direkt verbunden ist.

Die Leistungseinschübe 2 und Kühlkörper 3 sind in einem als Schaltschrank ausgebildeten gemeinsamen Gehäuse 4 angeordnet. Das Gehäuse 4 weist in seinem Inneren für jeden Leistungseinschub 2 wenigstens eine horizontale Verstrebung 5 auf, die den Leistungseinschub 2 stützt. Ferner weist das Gehäuse 4 in seinem Inneren wenigstens eine vertikale Verstrebung 6 auf, an der die Kühlkörper 3 mittels Kühlkörperhalterungen 7 befestigt sind.

Jeder Leistungseinschub 2 ist mit dem ihm zugeordneten Kühlkörper 3 kraftschlüssig mittels Schraubverbindungen 8 oder einer anderen kraftschlüssigen Verbindung verbunden. Ferner steht jeder Leistungseinschub 2 mit dem ihm zugeordneten Kühlkörper 3 thermisch über wenigstens ein horizontales Wärmeleitelement 9 und/oder wenigstens ein vertikales Wärmeleitelement 10 (so genannte Heatpipes) in thermischen Kontakt, durch welche die Wärmeleitung von dem Leistungseinschub 2 zu dem Kühlkörper 3 verbessert wird. Das Gehäuse 4 jedes Leistungseinschubes 2 ist vorzugsweise wenigstens in einem an dem zugeordneten Kühlkörper 3 anliegenden Bereich metallisch ausgeführt, um die Wärmeleitung von dem Leistungseinschub 2 zu dem Kühlkörper 3 weiter zu verbessern.

Wenigstens ein Gleichspannungswandler 1 ist Bestandteil einer sonst nicht näher dargestellten Brennstoffzellenanlage eines Unterseebootes mit wenigstens einer Brennstoffzelle. Dabei ist der wenigstens eine Gleichspannungswandler 1 elektrisch zwischen der wenigstens einen Brennstoffzelle und einem Bordnetz des Unterseebootes angeordnet, so dass mittels des wenigstens einen Gleichspannungswandlers 1 eine von der wenigstens einen Brennstoffzelle erzeugte elektrische Gleichspannung an die Bordnetzspannung angepasst werden kann.

Die Brennstoffzellenanlage umfasst ferner einen Primärkühlkreislauf, der ein Kühlmedium zur Kühlung des wenigstens einen Kühlkörpers der Kühlvorrichtung führt. Dieses Kühlmedium durchströmt die Kühlkörper 3, die somit Bestandteil des Primärkühlkreislaufs sind. Das Kühlmedium ist vorzugsweise Meerwasser oder Kühlwasser des Unterseebootes. Im Fall, dass es Kühlwasser des Unterseebootes ist, kann der Primärkühlkreislauf über einen Wärmetauscher thermisch an einen Meerwasser führenden Sekundärkühlkreislauf gekoppelt sein oder von einer bordeigenen Kühlanlage temperiert werden.

## Patentansprüche

1. Brennstoffzellenanlage eines Unterseebootes, umfassend wenigstens eine Brennstoffzelle, wenigstens einen mit der wenigstens einen Brennstoffzelle elektrisch verbundenen Gleichspannungswandler (1) zur Anpassung einer von der wenigstens einen Brennstoffzelle erzeugten Gleichspannung und einen Primärkühlkreislauf, der ein Kühlmedium führt, **dadurch gekennzeichnet, dass** der Gleichspannungswandler (1) wenigstens einen als Gleichspannungswandlermodul ausgebildeten Leistungseinschub (2) und eine mit dem Primärkühlkreislauf thermisch verbundene Kühlvorrichtung mit wenigstens einem Kühlkörper (3), der dazu ausgebildet ist, mittels des Kühlmediums gekühlt zu werden, und der in direktem thermischen Kontakt mit wenigstens einem Leistungseinschub (2) steht, umfasst, wobei der wenigstens eine Kühlkörper (3) mit wenigstens einem Leistungseinschub (2) kraftschlüssig verschraubt und/oder verspannt ist.

2. Brennstoffzellenanlage nach Anspruch 1,
**dadurch gekennzeichnet, dass** der wenigstens eine Kühlkörper (3) Teil des Primärkühlkreislaufs ist und dazu ausgebildet ist, von dem Kühlmedium durchströmt zu werden.

3. Brennstoffzellenanlage nach Anspruch 1 oder 2,
**dadurch gekennzeichnet, dass** der Primärkühlkreislauf Meerwasser als Kühlmedium führt.

4. Brennstoffzellenanlage nach Anspruch 1 oder 2,
**dadurch gekennzeichnet, dass** der Primärkühlkreislauf Kühlwasser des Unterseebootes als Kühlmedium führt.

5. Brennstoffzellenanlage nach Anspruch 4,
**gekennzeichnet durch** einen Meerwasser führenden Sekundärkühlkreislauf, der über einen Wärmetauscher thermisch an den Primärkühlkreislauf gekoppelt ist.

6. Brennstoffzellenanlage nach Anspruch 4,
**dadurch gekennzeichnet, dass** das Kühlwasser des Primärkühlkreislaufs durch eine bordeigene Kühlanlage des Unterseebootes gekühlt wird.

## Claims

1. Fuel cell system of a submarine, comprising at least one fuel cell, at least one DC-DC converter (1) electrically connected to the at least one fuel cell for adapting a DC voltage generated by the at least one fuel cell and a primary cooling circuit which supplies a cooling medium, **characterised in that** the DC-DC converter (1) comprises at least one power unit (2) designed as a DC-DC converter module and a cooling device with at least one cooling body (3) thermally connected to the primary cooling circuit which is designed to be cooled by means of the cooling medium, and which is in direct thermal contact with at least one power unit (2), wherein the at least one cooling body (3) is screwed and/or braced to at least one power unit (2) in a friction-type connection.

2. Fuel cell system according to claim 1,
**characterised in that** at least one cooling body (3) is part of the primary cooling circuit and is designed to be flowed through by the cooling medium.

3. Fuel cell system according to claim 1 or 2,
**characterised in that** the primary cooling circuit supplies sea water as a cooling medium.

4. Fuel cell system according to claim 1 or 2,
**characterised in that** the primary cooling circuit supplies cooling water from the submarine as a cooling medium.

5. Fuel cell system according to claim 4,
**characterised by** a secondary cooling circuit supplying sea water which is thermally connected to the primary cooling circuit via a heat exchanger.

6. Fuel cell system according to claim 4,
**characterised in that** the cooling water of the primary cooling circuit is cooled by an on-board cooling system of the submarine.

## Revendications

1. Installation à piles à combustible d'un sous-marin, comprenant au moins une pile à combustible, au moins un convertisseur (1) de tension continue, relié électriquement à la au moins une pile à combustible, pour l'adaptation d'une tension continue produite par la au moins une pile à combustible et un circuit de refroidissement primaire dans lequel passe un fluide de refroidissement, **caractérisée en ce que** le convertisseur (1) de tension continue comprend au moins un tiroir (2) de puissance, constitué sous la forme d'un module de convertisseur de tension continue, et un dispositif de refroidissement, qui est relié thermiquement au circuit de refroidissement primaire et qui a au moins un dissipateur (3) de chaleur, constitué de manière à être refroidi au moyen du fluide de refroidissement et en contact thermique direct avec le au moins un tiroir (2) de puissance, le au moins un dissipateur (3) de chaleur étant vissé et/ou bloqué à force sur au moins un tiroir (2) de puissance.

2. Installation à piles à combustible suivant la revendication 1,
**caractérisée en ce que** le au moins un dissipateur (3) de chaleur fait partie du circuit de refroidissement primaire et est constitué pour que le fluide de refroidissement y passe.

3. Installation à piles à combustible suivant la revendication 1 ou 2,
**caractérisée en ce que** le circuit de refroidissement primaire conduit de l'eau de mer comme fluide de refroidissement.

4. Installation à piles à combustible suivant la revendication 1 ou 2,
**caractérisée en ce que** le circuit de refroidissement primaire conduit de l'eau de refroidissement du sous-marin comme fluide de refroidissement.

5. Installation à piles à combustible suivant la revendication 4,
**caractérisée par** un circuit de refroidissement secondaire conduisant de l'eau de mer et couplé thermiquement par un échangeur de chaleur au circuit de refroidissement primaire.

6. Installation à piles à combustible suivant la revendication 4,
**caractérisée en ce que** l'eau de refroidissement du circuit de refroidissement primaire est refroidi par un système de refroidissement propre au bord du sous-marin.
